# EUROPÄISCHE PATENTANMELDUNG

(11) **EP 2 105 928 A1**
(43) Veröffentlichungstag der Anmeldung: **30.09.2009**
(21) Anmeldenummer: 08103017.3
(22) Anmeldetag: 27.03.2008
(51) Int. Cl.: G11B 20/18, G06F 11/10, H03M 13/35

(54) **Verfahren und Vorrichtung zum Speichern von Daten auf einem Speichermedium, Verfahren und Vorrichtung zum Korrigieren von Fehlern beim Lesen von Daten von einem Speichermedium sowie Speichermedium**

(71) Anmelder: Deutsche Thomson OHG, 30625 Hannover (DE)
(72) Erfinder: Winter, Marco, 30659 Hannover (DE)
(74) Vertreter: Thies, Stephan

(57) **Zusammenfassung**

Vorgefertigte Speichermedien werden beim Speichern audiovisueller Inhalte oft nicht vollständig beschrieben, es verbleibt ein Sonderbereich. Bekannte Aufzeichnungsformate sehen aus unterschiedlichen Gründen oft Bereiche vor, die frei von für eine Wiedergabe relevanter Information sind und daher einen weiteren Sonderbereich darstellen. Die Erfindung schlägt vor, aus den Daten des bekannten Aufzeichnungsformats Schutzinformationen zu bilden, die Schutzinformationen in den Sonderbereichen einzubetten und mit abzuspeichern, und im Fall von auftretenden Fehlern die Schutzinformationen zu einer Rekonstruktion der gelesenen Daten zu verwenden. Bevorzugt werden die Schutzinformationen eines bestimmten Bereichs in Sonderbereichen eines vorhergehenden Bereichs gespeichert, was eine Echtzeit-Korrektur ermöglicht.

## Beschreibung

Die Erfindung betrifft ein Verfahren und eine Vorrichtung zum Speichern von Daten auf einem Speichermedium gemäß den Ansprüchen 1 und 7, ein Verfahren und eine Vorrichtung zum Korrigieren von Fehlern beim Lesen von Daten auf einem Speichermedium gemäß den Ansprüchen 8 und 12, sowie ein Speichermedium gemäß Anspruch 14.

Die Verfahren sind besonders zum Herstellen von sogenannten Mastern, d.h. Abform-Vorlagen für z.B. CDs, DVDs, HD-DVDs und BDs sowie für DVD-Recorder bestimmt, die zum Beispiel im privaten Bereich zum Abspielen und/oder Speichern von Fernsehsendungen und Videos eingesetzt werden. Die Speichermedien sind z.B. Master, CDs und DVDs.

Wenn Video- und/oder Audiodaten in Form von digitalen Datensätzen auf einem Speichermedium gespeichert werden, was auch als Beschreiben des Speichermediums bezeichnet wird, erfolgt dies nach einer vorgegebenen, auch als "Format" oder "Standard" bezeichneten Konvention in Form von Datensätzen in einer Vielzahl von Sektoren. Hierbei wird in den meisten Fällen die Speicherkapazität des Speichermediums nicht voll ausgenutzt. Das bedeutet, dass auf dem Speichermedium noch freier Speicherplatz vorhanden ist.

Beim Lesen des Speichermediums, auch als Abspielen bezeichnet, kann es vorkommen, dass, trotz eines in der vorgegebenen Konvention enthaltenen Fehlerschutzes, ein oder mehrere Sektoren irreparabel beschädigt sind. Bei Audio-Datensätzen kann der Schaden bis zu einer bestimmten Grenze mit Hilfe einer Interpolations-Software kompensiert bzw. maskiert werden. Wird die Grenze des Maskierbaren überschritten, kommt es zu Aussetzern und/oder zum "Springen". Bei Video-Datensätzen dagegen ist eine nicht wahrnehmbare Kompensation bisher nicht möglich, und bei der Wiedergabe erscheinen kurze Standbilder oder sogenannte Blockartefakte.

Aufgabe der Erfindung ist es, ein Verfahren zum Speichern von Daten auf einem Speichermedium zu schaffen, bei dem die Daten so gespeichert werden, dass später eventuell auftretende Beschädigungen von Datensätzen während des Abspielens des Speichermediums repariert werden können.

Eine weitere Aufgabe der Erfindung ist es, ein Verfahren zum Korrigieren von Fehlern beim Lesen von auf einem Speichermedium gespeicherten Daten in einem Abspielgerät zu schaffen, das gegebenenfalls eine Fehlerkorrektur der auf dem Speichermedium gespeicherten Datensätze erlaubt.

Weitere Aufgaben bestehen in der Bereitstellung von Vorrichtungen, mit denen die erfindungsgemäßen Verfahren durchgeführt werden können.

Eine weitere Aufgabe besteht in der Bereitstellung eines Speichermediums, das solche Daten enthält, die eine schnelle und einfache Korrektur von fehlerhaften Datensätzen mit den erfindungsgemäßen Verfahren erlauben.

Die erste Aufgabe ist durch die Merkmale des Anspruchs 1 gelöst. Zusätzlich zu ersten Datensätzen, die insgesamt eine nach einer vorgegebenen Konvention zu speichernde und nach derselben Konvention wiedergebbare Datenmenge repräsentieren, und Sonderbereiche an unregelmäßigen Positionen enthalten, die beim Lesen gemäß der vorgegebenen Konvention nicht verwendet werden, werden Schutzdatensätze gebildet. Die ersten Datensätze und die Schutzdatensätze werden gemeinsam auf dem Speichermedium gespeichert. Jeder der Schutzdatensätze enthält Schutzinformationen über Teile der ersten Datensätze, die so geartet sind, dass sie eine Wiederherstellung fehlerhafter erster Datensätze erlauben und selbst nur relativ wenig Speicherplatz beanspruchen.

Bei bekannten Speicherverfahren werden die Daten nach der vorgegebenen Konvention in Bereiche aufgeteilt und so auf dem Speichermedium gespeichert. Bei Video-Daten ist z.B. gebräuchlich der Bereich VOBU = Video Object Unit entsprechend circa 0,5 Sekunden Spielzeit. Die Bereiche können, sogar innerhalb einer Aufnahme, sowohl hinsichtlich ihrer Wiedergabedauer als auch hinsichtlich ihres Datenumfangs variieren. Unabhängig von dieser Aufteilung ist es weit verbreitet, dass die Daten in Sektoren konstanter Größe des Speichermediums abgespeichert werden; mit der zusätzlichen Vereinbarung, dass jeder dieser Sektoren Daten ausschließlich eines bestimmten Datentyps enthält. Als Datentypen werden unter anderem unterschieden Audiodaten, Videodaten, Untertiteldaten, oder Navigationsdaten. Bei einer Video-Quellencodierung nach dem MPEG-2 Standard werden die Videodaten noch weiter unterteilt in sogenannte "I-Picture Daten" für Einzelbilder, die ohne Bezug auf andere Bilddaten der Bildfolge dekodiert werden können, "P-Picture Daten", welche zum Dekodieren den Bezug auf genau ein vorher im Datenstrom übertragenes Bild der Bildfolge erfordern, und "B-Picture Daten", welche zum Dekodieren den Bezug auf genau zwei vorher im Datenstrom übertragene Bilder der Bildfolge erfordern.

Gemäß der vorgegebenen Konvention sind in den meisten Fällen in den zum Speichern auf dem Speichermedium formatierten Daten sowohl am Ende als auch in manchen der verwendeten Sektoren noch Speicherplätze frei. Dies umfasst einen am Ende freibleibenden Platz immer dann, wenn der Gesamtumfang der aufzuzeichnenden Daten nicht genau der Speicherkapazität des Speichermediums entspricht. Es umfasst aber auch die Fälle, wo gemäß der vorgegebenen Konvention Teile von Sektoren oder gewisse ganze Sektoren als reservierte Bereiche unbeschrieben bleiben oder mit Pseudodaten, oft auch als "Dummydaten" bezeichnet, gefüllt werden. Beide Arten von Bereichen werden im Folgenden zusammen als "Sonderbereiche" bezeichnet. Gemeinsames Kennzeichen der Sonderbereiche ist also, dass die in ihnen enthaltenen Daten beim Lesen der ersten Datensätze gemäß der vorgegebenen Konvention nicht verwendet oder benötigt werden.

Die Erfindung macht sich die Sonderbereiche zunutze, indem sie genau hier die Schutzdatensätze speichert. Ausgenutzt wird die Tatsache, dass die Sonderbereiche beim Auslesen gemäß der vorgegebenen Konvention von vorn herein übersprungen oder gar nicht weiter beachtet werden. Mit anderen Worten ist für das Auslesen gemäß der vorgegebenen Konvention der Inhalt der Sonderbereiche irrelevant. Dies gewährleistet, dass auch wenn in diesen Sonderbereichen andere Daten als ggf. gemäß der vorgegebenen Konvention vorgeschrieben abgespeichert werden, der Vorgang des konventionsgemäßen Abspielens in einem Abspielgerät des Standes der Technik nicht beeinträchtigt ist. Die erfindungsgemäßen Verfahren sind also alle abwärtskompatibel zu der vorgegebenen Konvention. Mit anderen Worten: Ein Speichermedium, das Schutzdatensätze gemäß der Erfindung eingebettet in die ersten Datensätze enthält, lässt sich auch auf einem Abspielgerät des Standes der Technik gemäß der vorgegebenen Konvention abspielen - dort allerdings ohne die Vorteile des zusätzlichen Fehlerschutzes.

Durch die Unterbringung von Schutzdatensätzen in den Sonderbereichen stehen später beim Lesen des Datenträgers in einer Vorrichtung gemäß der Erfindung die Schutzinformationen zur Verfügung, mit denen gegebenenfalls beschädigte erste Datensätze repariert werden können. Beim Abspielen der erfindungsgemäß gespeicherten Daten auf einem erfindungsgemäßen Abspielgerät werden nicht nur die ersten Datensätze konventionsgemäß ausgelesen, sondern auch die Schutzdatensätze ausgelesen und ggf. zwischengespeichert. Das erfindungsgemäße Abspielgerät führt bei Auftreten von fehlerhaften ersten Datensätzen eine Korrektur durch, indem es die ersten Datensätze und die Schutzdatensätze verknüpft, und erreicht immer dann eine fehlerfreie Wiedergabe, wenn nicht zu viele fehlerhafte erste Datensätze vorliegen. Ein Gebrauchsspuren bestimmter Stärke aufweisender Datenträger, der auch Schutzdatensätze gemäß der Erfindung umfasst, erzeugt beim Abspielen in einem erfindungsgemäßen Abspielgerät auch dann keine Wiedergabestörungen, wenn beim Abspielen in einem Abspielgerät des Standes der Technik bereits Störungen auftreten.

Das erfinderische Verfahren ist für das Speichern von Daten auf verschiedenen Speichermedien einsetzbar. Es kann z.B. angewendet werden beim Herstellen eines sogenannten Masters, d.h. eines Zwischenprodukts, das selbst zur Massenfertigung eines Endprodukts "vorbespielter Datenträger" verwendet wird.

Der Master, und damit auch alle mit ihm hergestellten Endprodukte, enthalten dann zusätzlich zu den konventionsgemäßen ersten Datensätzen auch die Schutzdatensätze. Weitere Anwendungsmöglichkeiten bestehen z.B. beim "Brennen" und/oder Kopieren von CDs/DVDs. Da das Verfahren Besonderheiten der optischen Datenspeicherung nicht ausnutzt, ist es ebenso auch für Speichermedien gemäß anderer physikalischer Prinzipien, z.B. magnetische, anwendbar.

Bevorzugt werden die Schutzdatensätze auf dem Speichermedium so angeordnet, dass mit den darin enthaltenen Schutzinformationen eine Fehlerkorrektur der ersten Datensätze in Echtzeit erfolgen kann. Hierbei sind die Daten in eine Folge von nacheinander wiederzugebenden Bereichen unterteilt, und die zu den ersten Datensätzen eines Bereichs gebildeten Schutzdatensätze werden zusammen mit den ersten Datensätzen mindestens eines der vorherigen Bereiche abgespeichert. Im Falle von Videodaten kann als Bereich beispielsweise eine VOBU gewählt und vereinbart werden, sodass die Schutzdatensätze einer VOBU Nr. (n) zusammen mit den ersten Datensätzen der vorherigen VOBUs Nr. (n-1) und/oder (n-2) abgespeichert werden. Auf diese Weise liegen beim Abspielen die in den Schutzdatensätzen enthaltenen und zu einem Bereich gehörenden Schutzinformationen bereits fertig ausgelesen vor, wenn unter den ersten Datensätzen des Bereichs gegebenenfalls ein defekter erster Datensatz entdeckt wird. Damit ist eine sehr schnelle Wiederherstellung der defekten Daten möglich. Bei Verletzung des Kriteriums, dass die zu einem Bereich gehörenden Schutzdatensätze vor den ersten Datensätzen des Bereichs eingebettet sein sollen, müsste man bei Feststellen eines defekten ersten Datensatzes auf dem Speichermedium zurückspringen.

In einer weiteren Ausbildung der Erfindung umfassen die Schutzinformationen Paritätsdaten, die aus den ersten Datensätzen gebildet werden. Die Paritätsdaten sind exklusiv-oder-verknüpfte Daten, auch als EXOR Daten bezeichnet, die automatisch und mit wenig Realisierungsaufwand aus den ersten Datensätzen generiert werden. Sie werden zwischengespeichert und auf dem Speichermedium in den Sonderbereichen gespeichert. Anstelle bereichsweise hergeleiteter Paritätsdaten sind auch andere Fehlerschutzdaten gemäß bekannten Verfahren der fehlerkorrigierenden Codierung, z.B. aus Blockcodes oder Faltungscodes verwendbar.

Weiterhin ist es möglich, für jeden Bereich zwei Schutzdatensätze zu bilden und zu speichern, wobei einer über ungeradzahlige und der andere über geradzahlige erste Datensätze des Bereichs gebildet wird. Hierdurch wird es möglich, auch in denjenigen Fällen Daten zu reparieren, d.h. Fehler zu korrigieren, wenn innerhalb eines Bereichs zwei defekte erste Datensätze mit ungeradzahligem Abstand, insbesondere also auch zwei direkt benachbarte defekte erste Datensätze, vorliegen. Der inkaufzunehmende Nachteil ist in diesem Fall, dass der Umfang der Schutzdatensätze sich bei ansonsten gleichbleibenden Gegebenheiten verdoppelt. Auch Verallgemeinerungen auf drei und mehr Schutzdatensätze pro Bereich sind aus dem Gebiet der RAID-Technik bekannt.

Gemäß einer weiteren Variante der Erfindung wird ausgenutzt, dass audiovisuelle Daten ganz allgemein für das Abspielen notwendige, wesentliche oder wichtige, Daten und weniger wichtige Ergänzungsdaten enthalten. Die Variante besteht darin, dass die in den Schutzdatensätzen unterzubringenden Schutzinformationen ausschließlich aus als wesentlich vereinbarten Teilen der ersten Datensätze gebildet werden.

Wenn man davon ausgeht, dass ein Schutzdatensatz für konstant viele erste Datensätze bereitgestellt werden soll, reduziert die Beschränkung auf die wesentlichen ersten Datensätze die als Schutzdatensätze zusätzlich zu speichernde Datenmenge und damit den erforderlichen freien Speicherplatz. Wenn man in einem alternativen Ansatz von einer konstanten Anzahl von Schutzdatensätzen pro Bereich ausgeht, tritt der mit den Verfahren gemäß der Erfindung schützbare Fall, dass genau einer der zu einem Schutzdatensatz gehörenden ersten Datensätze defekt ist, bei umso größeren Fehlerwahrscheinlichkeiten auf, je geringer die Anzahl von ersten Datensätzen pro Schutzdatensatz ist. Je nach Art und Umfang der als wichtig ausgewählten ersten Datensätze ermöglicht ihr Schutz durch zugeordnete Schutzdatensätze, dass bei Auftreten des schützbaren Falles die Daten ganz ohne sichtbare bzw. hörbare Fehler oder mit nur geringen Fehlern wiedergegeben werden können.

Der Ansatz, die ersten Datensätze in wichtige und unwichtige aufzuteilen und vereinbarungsgemäß die Schutzdatensätze nur aus den wichtigen Daten der ersten Datensätze zu bilden, kann beispielhaft in der Form realisiert werden, dass die Schutzinformationen aus nur einem Teil der Datenarten I-Picture Daten, P-Picture Daten, B-Picture Daten und Nicht-Video Daten gebildet werden. Unter diesen sind die I-Picture-Daten, da sie sowohl zu ihrer eigenen Decodierung, als auch zur Decodierung der sich auf sie beziehenden P-Pictures und B-Pictures benötigt und verwendet werden, als am wichtigsten anzusehen. Bei einem begrenzten, zum Fehlerschutz gemäß der Erfindung zur Verfügung stehenden Datenstrom wird man also im Allgemeinen mit oberster Priorität die I-Picture Daten schützen.

Das erfindungsgemäße Verfahren ist an das aus der Computertechnik bekannte "RAID 5" Verfahren angelehnt. Bei diesem werden von zu speichernden Daten Paritätsdaten gebildet und gleichmäßig nach einem vorbestimmten System auf mehrere Festplatten gespeichert.

Eine erfindungsgemäße Vorrichtung zum Speichern von Daten gemäß der Merkmale des Anspruchs 7 erlaubt die Durchführung des erfindungsgemäßen Speicherverfahrens.

Die Aufgabe, ein Verfahren zum Korrigieren zu schaffen, ist durch die Merkmale des Anspruchs 8 gelöst. Das erfindungsgemäße Verfahren erlaubt beim Lesen von Daten eine Korrektur von fehlerhaften ersten Datensätzen. In den meisten Fällen kann dies in Echtzeit erfolgen. Das Verfahren erlaubt das fehlerfreie Abspielen von z.B. DVDs, selbst wenn erste Datensätze beschädigt sind. Die Fehler werden also von einem Benutzer nicht bemerkt.

In einer Variante nach Anspruch 9 werden die korrigierten ersten Datensätze auf einem beschreibbaren, nichtflüchtigen Datenspeicher des Abspielgeräts gespeichert. Hierdurch ist das fehlerfreie Abspielen erleichtert und ein späteres Abspielen des nicht beschreibbaren Speichermediums selbst dann fehlerfrei möglich, wenn dieses im Laufe der Zeit z.B. durch weitere mechanische Abnutzung so schlecht wird, dass irgendwann die fehlerhaften ersten Datensätze ausschließlich aus den Daten des Mediums nicht mehr korrigiert werden können.

Es ist vorteilhaft, wenn die in dem beschreibbaren, nichtflüchtigen Datenspeicher des Abspielgeräts gespeicherten Schutzinformationen zusätzlich eine Kennung des Speicherbereichs, zu dem sie gehören, umfassen. Eine solche Kennung besteht beispielhaft aus einer Kennung des Speichermediums und einer Bereichskennung. Das Vorliegen einer Speicherbereichskennung erlaubt es, dass die Schutzinformationen direkt einem bestimmten nicht beschreibbaren Speichermedium und auf diesem den fehlerhaften ersten Datensätzen zugeordnet werden. Dies erleichtert und beschleunigt das spätere fehlerfreie Abspielen.

In einer weiteren Ausgestaltung der Erfindung gemäß den Merkmalen von Anspruch 10 werden nicht nur korrigierte fehlerhafte erste Datensätze auf dem beschreibbaren Datenspeicher des Abspielgeräts gespeichert, sondern zusammen mit diesen auch ihnen benachbarte erste Datensätze. Dies berücksichtigt, dass benachbarte erste Datensätze mit hoher Wahrscheinlichkeit in relativ kurzer Zeit, z.B. bei geringfügig weiter fortschreitender mechanischer Abnutzung des Speichermediums, fehlerhaft werden, und beugt daher einer möglichen Unleserlichkeit vor.

An einen Benutzer des Abspielgeräts wird nach Anspruch 11 eine Aufforderung zum Sichern des optischen Speichermediums ausgegeben, sobald dieses eine bestimmte Mindestanzahl von Fehlern aufweist. Dies bewirkt, dass der Benutzer eine Kopie des optischen Speichermediums anfertigen kann, bevor dieses gänzlich oder in Teilen unlesbar wird.

Eine erfindungsgemäße Vorrichtung zum Korrigieren von Fehlern gemäß der Merkmale des Anspruchs 12 erlaubt die Durchführung des erfindungsgemäßen Korrekturverfahrens.

Die Aufgabe, ein Speichermedium bereitzustellen, ist durch die Merkmale des Anspruchs 14 gelöst. Das Speichermedium enthält Schutzdatensätze, die Schutzinformationen über die ersten Datensätze enthalten. Hierbei sind die Schutzdatensätze auf dem Speichermedium an den Stellen gespeichert, die gemäß der vorgegebenen Konvention frei bleiben würden. Dies gewährleistet, dass das Speichermedium auch dann noch fehlerfrei abspielbar ist, wenn erste Datensätze infolge z.B. von Kratzern Fehler aufweisen. Wenn das Speichermedium ein Master ist, können von diesem z.B. als Massenprodukt für Endverbraucher entsprechende Medien hergestellt werden, die alle Daten des Masters und damit auch die Schutzdatensätze enthalten.

Den unabhängigen Ansprüchen liegt die verbindende erfinderische Idee zugrunde, dass aus ersten Datensätzen, die zum Lesen von Daten erforderlich sind, Schutzdatensätze gebildet werden, die Schutzinformationen über die ersten Datensätze enthalten, und dass diese Schutzdatensätze an Stellen abgespeichert werden, die gemäß einer vorgegebenen Konvention freibleiben. Die Schutzinformationen erlauben eine Korrektur von in den ersten Datensätzen gegebenenfalls auftretenden Fehlern, so dass die Daten weiterhin fehlerfrei ausgegeben werden können.

Die Erfindung wird anhand der in den Zeichnungen dargestellten Beispiele und der abhängigen Patentansprüche weiter erläutert. Hierbei zeigen
- Figur 1: einen beispielhaften Verlauf eines Datenstroms,
- Figur 2: eine Bildung von Paritätsdaten,
- Figur 3: ein Speichern eines Paritätsblocks,
- Figur 4: ein Speichern eines aus Clustern gebildeten Paritätsblocks,
- Figur 5: ein zu Figur 4 alternatives Speichern von aus Clustern gebildeten Paritätsblöcken und
- Figur 6: ein Blockschaltbild eines erfindungsgemäßen Abspielgeräts.

Eine Vorrichtung zum Speichern von Daten auf einem Speichermedium umfasst mindestens einen internen beschreibbaren Datenspeicher, Mittel zum Lesen von und Schreiben auf dem internen Datenspeicher und dem Speichermedium sowie Mittel zum Ausgeben von Daten. Zusätzlich sind Mittel zum Bilden von Schutzdatensätzen aus ersten Datensätzen, Mittel zum Zwischenspeichern der Schutzdatensätze auf dem internen Datenspeicher und Mittel zum Speichern der ersten Datensätze und der Schutzdatensätze auf dem Speichermedium angeordnet. Mindestens ein Prozessor mit einer zugehörigen Peripherie verwaltet die verschiedenen Mittel und führt erforderliche Operationen aus. Der interne Datenspeicher umfasst mindestens einen Arbeitsspeicher.

Die Vorrichtung ist z.B. im gewerblichen Bereich ein Gerät zum Herstellen von Mastern oder im privaten Bereich ein Recorder für optische Speichermedien. Das Speichermedium ist entsprechend z.B. eine Masterplatte beziehungsweise eine beschreibbare oder wiederbeschreibbare CD oder DVD oder ein anderes Speichermedium.

Zum Speichern werden Daten, die mindestens einen digitalisierten Audio-Video-datenstrom, auch als AV-Datenstrom bezeichnet, oder Audio-Datenstrom enthalten, in die Vorrichtung zum Speichern übertragen. Diese Daten umfassen erste Datensätze, die zum Lesen der Daten nach der vorgegebenen Konvention erforderlich sind.

Die Daten werden kontinuierlich auf dem internen Datenspeicher zwischengespeichert und von dem Prozessor verarbeitet. Hierbei werden die Daten entsprechend der vorgegebenen Konvention in Bereiche und die Bereiche weiter in Sektoren unterteilt, falls die Daten nicht bereits derart unterteilt in die Vorrichtung zum Speichern eingespeist werden. Bei AV-Daten entspricht ein Bereich z.B. einer VOBU. Jeder Sektor enthält gemäß der Konvention nur Daten eines bestimmten Datentyps, z.B. Audio, Video, Untertitel oder Navigation. Dabei weist jeder Sektor einen Pack header aus MPEG2 Daten auf. Wenn also in einem Bereich ein Datentyp nur wenige Daten umfasst oder überhaupt nicht vorhanden ist, bleiben zumindest Teile der entsprechenden Sektoren nach der vorgegebenen Konvention mehr oder weniger frei. Weiterhin entspricht die auf dem Speichermedium zu speichernde Datenmenge in den seltensten Fällen der Speicherkapazität des Speichermediums. Daher verbleibt nach der Konvention auch nach dem Speichern fast immer freier Speicherplatz auf dem Speichermedium.

Bei der Verarbeitung der Daten werden zusätzlich Schutzdatensätze gebildet. Diese enthalten Schutzinformationen über die ersten Datensätze. Die Schutzinformationen erlauben eine Korrektur der ersten Datensätze, falls hier Fehler auftreten.

Die Schutzdatensätze umfassen Paritätsdaten, die aus bestimmten Sektorsequenzen der ersten Datensätze berechnet werden. Die Paritätsdaten werden dann in EXOR- Sektoren zu Paritätsblöcken zusammengefasst. Dies erfolgt ähnlich dem RAID 5-System bei der Sicherung und Verwaltung von mehreren Festplatten, die in einem Computer angeordnet sind. Der EXOR-Sektor entsteht durch die Exklusiv-Oder-Verknüpfung von gleichrangigen Bytes mehrerer Sektoren. So entsteht das x-te Byte des EXOR-Sektors durch die Exklusiv- Oder-Verknüpfung des jeweils x-ten Bytes der zugeordneten Sektoren. Bevorzugt werden dem EXOR-Sektor oder seinen abzuspeichernden Teilen noch Zuordnungsdaten beigefügt, welche z.B. die Adresse und Länge der VOBU angeben, aus der der EXOR-Sektor entstanden ist. Weitere EXOR-Sektoren können z.B. für andere Video-Sektoren und/oder nur für die I-Picture Daten eines nach MPEG codierten Videodatenstroms gebildet werden. Letztere stellen eine Teilmenge von für das Abspielen besonders wichtigen Video-Sektoren dar.

Vorteilhafterweise werden die Paritätsdaten ausschließlich von wichtigen Datenarten gebildet. Hierzu zählen z.B. Videodaten, I-Picture Daten, P-Picture Daten und B-Picture Daten. Navigations- und Untertiteldaten sind dagegen weniger relevant und können daher ausgespart werden.

Auch innerhalb der wichtige Datenarten enthaltenden Sektoren sind u.U. nur Teile tatsächlich für die Wiedergabe relevant, andere Teile können relativ einfach rekonstruiert werden. Solche Daten sind z.B. Packheader und Packet header. Daher können auch diese Daten von der Bildung von Paritätsdaten ausgespart werden.

Zusätzliche Datensicherheit wird dadurch erreicht, dass zwei erste Datensätze über die Sektoren eines Bereichs gebildet werden. Einer dieser erste Datensätze wird dabei über ungeradzahlige und ein weiterer über geradzahlige Sektoren gebildet. Dies ermöglicht gegebenenfalls die Rekonstruktion von zwei benachbarten unlesbaren Sektoren im Bereich.

Die Bildung der Schutzdatensätze kann parallel mit dem Speichern der ersten Datensätze auf dem Speichermedium erfolgen.

Die Schutzdatensätze werden auf dem internen Speichermedium zwischengespeichert. Aus dem internen Speichermedium werden die Schutzdatensätze auf dem Speichermedium gespeichert. Dies erfolgt an den Stellen des Speichermediums, die beim Speichern der ersten Datensätze nach der vorgegebenen Konvention frei bleiben opder nur mit Pseudodaten oder Dummydaten gefüllt sind. Hierbei werden bevorzugt die Schutzdatensätze der VOBU Nr. (n) an den freien Stellen der in Auslesereihenfolge vorherigen VOBUs Nr. (n-1) und/oder Nr. (n-2) gespeichert.

In Fällen, wo der erfindungsgemäße zusätzliche Fehlerschutz besonders stark ausgeführt werden soll, kann - sogar ohne Verletzung der vorgegebenen Konvention über das Format der ersten Datensätze - zusätzlicher freier Bereich dadurch erzeugt werden, dass die Payload eher selten vorkommender Pakete, z.B. Sub-picture Pakete, über mehr Sektoren verteilt wird, als aufgrund ihres Datenvolumens erforderlich wäre.

Sollte die Speicherkapazität der freien Bereiche in der VOBU Nr. (n-1) oder (n-2) nicht für alle Schutzdatensätze der VOBU Nr. (n) ausreichen, so wird eine Auswahl nach ihrer Wichtigkeit getroffen und die wichtigsten Schutzdatensätze werden zuerst gespeichert. Die restlichen Schutzdatensätze werden am Ende des Datenstroms angehängt, falls dort genügend freie Stellen vorhanden sind. Ein solches Vorgehen ermöglicht bei Datenfehlern eine Echtzeit-Rekonstruktion. Auch am Ende des Datenstroms können die Schutzdatensätze entsprechend ihrer Wichtigkeit gespeichert werden, falls der Speicherplatz nicht für alle ausreicht.

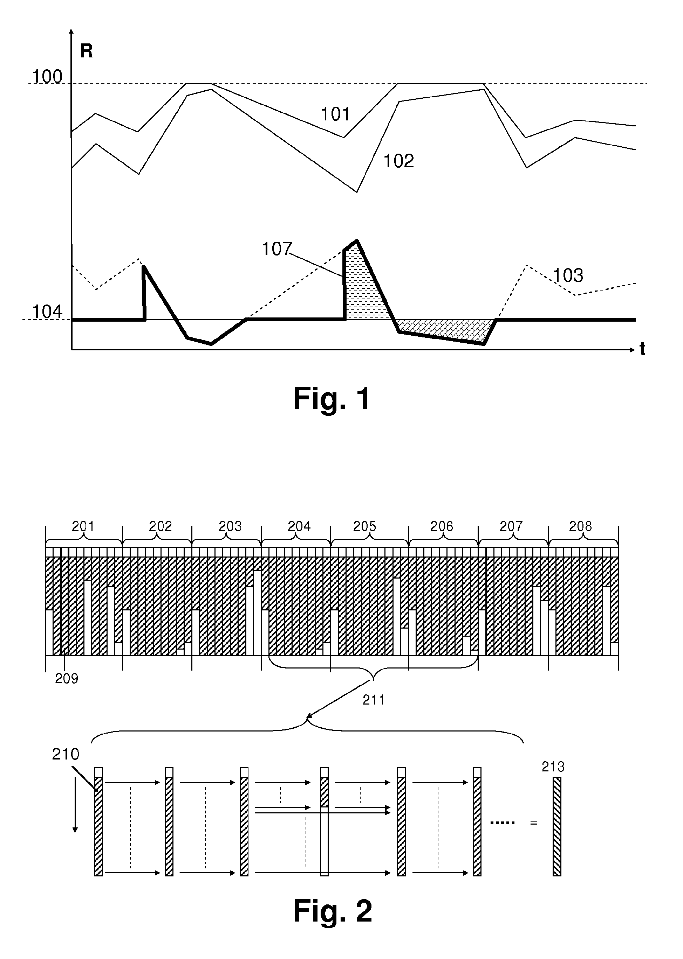

Auf diese Weise wird mindestens ein Speichermedium hergestellt. Damit stehen auf dem Speichermedium Schutzinformationen zur Verfügung, die eine Fehlerkorrektur bei einem späteren Abspielen ermöglichen. Die Vorgänge werden anhand der Figuren 1 bis 5 weiter beschrieben.

Wie oben beschrieben werden von den ersten Datensätzen Schutzdatensätze gebildet, so dass sich der Umfang der insgesamt zu speichernden Daten aus der Summe der Umfänge beider Arten von Datensätzen ergibt. **Figur 1** zeigt ein Beispiel für Datenströme R, die bei einer Anwendung des erfindungsgemäßen Verfahrens über der Zeit t auftreten können. Eine obere horizontale Linie 100 zeigt diejenige angenommene konstante Datenrate, die maximal durchgehend vom Speichermedium gelesen werden kann. Eine obere veränderliche Linie 101 zeigt den zeitlichen Verlauf des Datenstroms, der gemäß der vorgegebenen Konvention für ein angenommenes Beispiel-AV-Material entsteht. Wie oben beschrieben, enthält dieser Datenstrom auch Sonderbereiche. Eine mittlere veränderliche Linie 102 zeigt den zeitlichen Verlauf des Datenstroms ohne diese Sonderbereiche, d.h. den zeitabhängigen Umfang der für eine Wiedergabe gemäß der vorliegenden Konvention wirklich erforderlichen Daten. Der vertikale Abstand zwischen den Linien 101 und 102 gibt also für jeden Zeitpunkt t den momentanen Umfang der oben näher beschriebenen Sonderbereiche an, er stellt somit die unmittelbar für die Zwecke des erfindungsgemäßen Verfahrens verfügbare Bitrate dar. Durch zusätzliche Modifikationen der Zeitmarken der Sektoren, oder durch andere Modifikationen des Codierverfahrens gemäß der vorgegebenen Konvention kann insgesamt maximal ein Bitstrom für die Zwecke des erfindungsgemäßen Verfahrens verwendet werden, dessen Größe sich aus dem positiven Abstand zwischen den Linien 100 und 102 ergibt. Diese Bitrate ist in Fig. 1 auch einzeln bzw. nicht-inkrementell als gestrichelte Linie 103 dargestellt. Fig. 1 zeigt auch, als untere horizontale Linie 104, eine benötigte mittlere Schutzbitrate, die in Grenzen beliebig gewählt werden kann. Für das in der Figur dargestellte Beispiel ist ein bestimmter Wert, deutlich kleiner als die Gesamtbitraten der Linien 101 oder 102 angenommen.

Die untere, fett gezeichnete veränderliche Linie 107 von Fig. 1 gibt den Zeitverlauf der Größe des tatsächlich für den erfindungsgemäßen Fehlerschutz verwendeten Datenstroms wieder. Es ist gezeigt, dass zu allen Zeiten t, wo die zur Verfügung stehenden Sonderbereiche es erlauben, die Schutzdatensätze mit der konstanten benötigten mittleren Schutzbitrate erzeugt und abgespeichert werden.

Da die maximale Datenmenge "max" nicht überschritten werden darf, und auf manchen Abspielgeräten nicht überschritten werden kann, werden an zeitlichen Positionen des Datenstroms, wo die maximale Datenmenge erreicht ist, die dazugehörigen Schutzdatensätze in solchen vorhergehenden VOBUs gespeichert, die noch genügend freie Speicherkapazität haben. Hierbei werden die Schutzdatensätze zu den ersten Datensätzen der VOBU Nr. (n) in der VOBU Nr (n-1) und gegebenenfalls in weiteren vorhergehenden VOBUs (n-2) etc. gespeichert, wobei zu berücksichtigen ist, dass die Schutzdatensätze einer der VOBUs immer vor den Schutzdatensätzen einer nachfolgenden VOBU zu speichern sind. Der Abstand zwischen einer VOBU und dem Speicherort der zugehörigen Schutzdatensätze soll dabei möglichst klein sein, was eine schnelle Verfügbarkeit der Schutzdatensätze im Fall einer erforderlichen Reparatur gewährleistet.

Das Puffern der Schutzdatensätze ist am besten bei einer Offline Enkodierung möglich, weil bei einer Echtzeit Enkodierung wesentlich mehr Zwischenspeicherplatz vorhanden sein muss.

In **Figur 2** ist das Bilden der Schutzdatensätze in Form von Paritätsdaten verdeutlicht. Hier werden vorzugsweise nur von den wichtigen Datenarten Paritätsdaten gebildet und zu einem Paritätsblock 213 zusammengefasst. Im oberen Teil von Fig. 2 sind Sektoren 209 aufeinanderfolgender VOBUs 201, ..., 208 gezeigt, wobei die für die Paritätsbildung wichtigen Daten durch rechts-diagonale Schraffur gekennzeichnet sind und die unwichtigen Daten ohne Schraffur. Für die wichtige Daten enthaltenden Sektoren dreier aufeinanderfolgender VOBUs 204, 205, 206 ist im unteren Teil von Fig. 2 die Bildung des Paritätsblocks 213 genauer gezeigt. Der Paritätsblock 213 ist in der Figur durch links-diagonale Schraffur gekennzeichnet. Insbesondere ist in der Mitte des unteren Teils von Fig. 2 gezeigt, dass bei Sektoren, die sowohl wichtige als auch unwichtige Daten enthalten, die wichtigen Daten in die Paritätsbildung mit eingehen, während die unwichtigen Daten, deren Lage bekannt ist, bei der Paritätsbildung übergangen bzw. ausgelassen werden. Gleich indizierte Bytes aller wichtigen Datenbereiche 210 der beteiligten Sektoren werden jeweils verknüpft, wie in Fig. 2 unten durch Pfeile von links nach rechts angedeutet, und bilden jeweils ein Byte des Paritätsblocks 213. Die Anzahl der VOBUs, über deren Sektoren jeweils ein Paritätsblock 213 gebildet wird, d.h. mit anderen Worten die Größe der Bereiche, kann auch dynamisch in Abhängigkeit von den im jeweiligen Bereich verfügbaren freien Speicherplätzen variieren. Dies ist unten näher beschrieben.

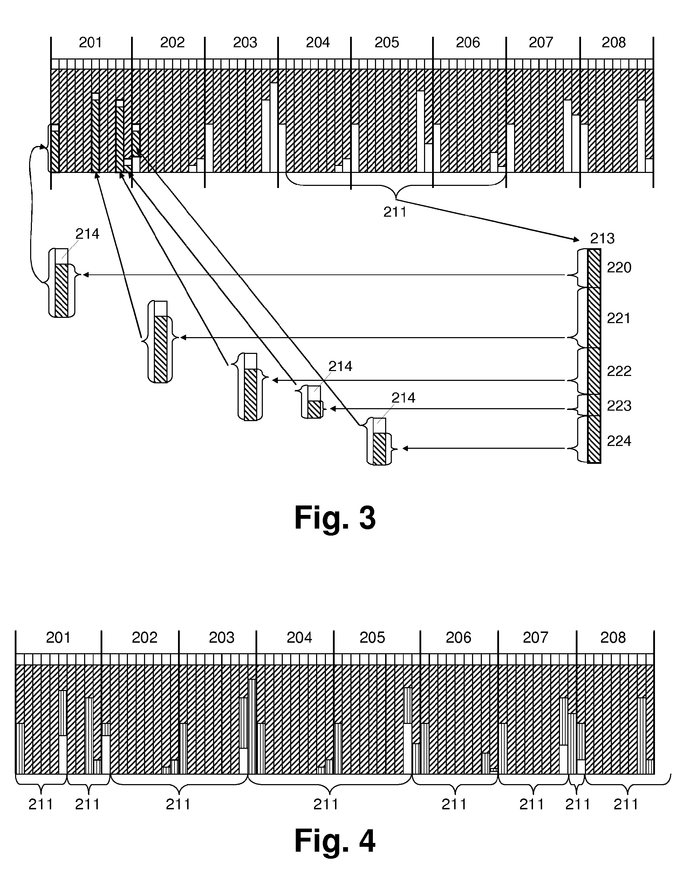

**Figur 3** zeigt beispielhaft, wie der aus den wichtigen Daten eines Bereichs 211 gebildete Paritätsblock 213 abgespeichert wird. Hierzu wird der Paritätsblock 213, wieder durch links-schräge Schraffur gekennzeichnet, in passend große Teile 220, 221, 222, 223, 224 aufgeteilt, und jeder dieser Teile wird zusammen mit einem vorangestellten Header 214 in einem der Sonderbereiche der Sektoren vorhergehender VOBUs 201, 202 gespeichert, das heißt abgelegt. Da die Größe und Lage der Sonderbereiche bei Dekodierung des Datenstroms gemäß der vorgegebenen Konvention bekannt ist, steht auch die Größe der aufzuteilenden Teile fest und muss nicht noch einmal gesondert abgespeichert oder kenntlich gemacht werden.

Das in Fig. 3 gezeigte Beispiel basiert auf der Annahme, dass aus jeweils drei aufeinanderfolgenden VOBUs in der beschriebenen Weise ein Paritätsblock 213 gebildet wird. Alternativ kann der Paritätsblock 213 auch über eine dynamisch variierende oder feste Anzahl von Sektoren ohne Rücksicht auf Grenzen der VOBUs gebildet werden. Hierbei wird dann der Datenstrom in Sektor Cluster aufgeteilt, und die Größe des Sektor Clusters wird so gewählt, dass er in seinen Sonderbereichen gerade so viel freien Speicherplatz aufweist, dass der Paritätsblock des nachfolgenden Sektor Clusters darin gespeichert werden kann.

**Figur 4** zeigt symbolisch einen Datenstrom dessen Sektoren zu aufeinanderfolgenden VOBUs 201, ..., 208 gehören und in Abhängigkeit von der Größe der in ihnen enthaltenen Sonderbereiche zu variabel großen Sektor Clustern 211 zusammengefasst sind. In den Sonderbereichen jedes Sektor Clusters ist der über die wichtigen Daten des nachfolgenden Sektor Clusters gebildete Paritätsblock abgespeichert. Zur besseren Übersichtlichkeit sind dabei in Fig. 4 die Teile der Paritätsblöcke durch senkrechte Schraffur, und die nicht benutzen Teile der Sonderbreiche ohne Schraffur gekennzeichnet. Insbesondere ist ersichtlich, unter Anderem im vorletzten Sektor der VOBU 207, dass der letzte innerhalb jedes Sector Clusters zum Abspeichern des Endes des Paritätsblocks verwendete Sonderbereich bei dieser Datenanordnung nur teilweise verwendet wird; der Rest des Sonderbereichs bleibt leer.

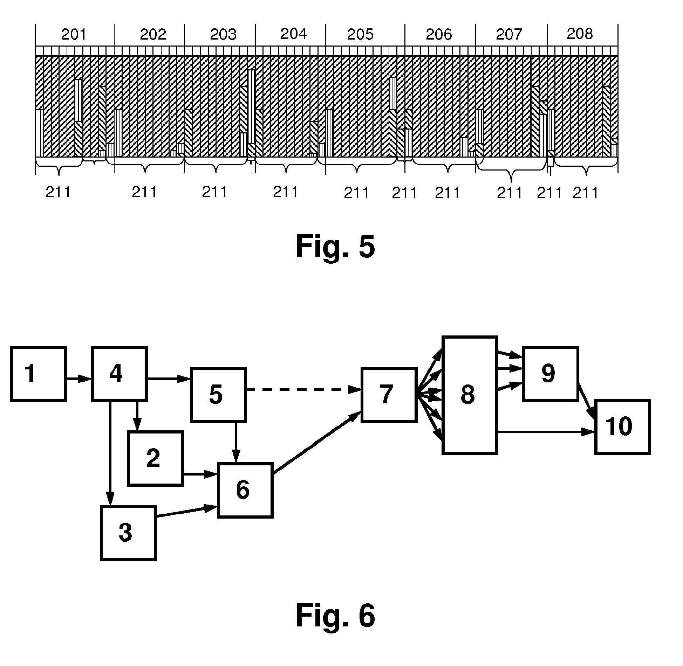

**Figur 5** zeigt eine alternative Datenanordnung, die diesen Nachteil vermeidet. Auf diese Weise kann der freie Speicherplatz insgesamt noch besser genutzt werden, und eine verbesserte Korrektur von defekten Datensätzen ist gewährleistet. Wieder ist angenommen, dass als Ende jedes Sektor-Clusters 211 derjenige Sektor gilt, dessen Sonderbereich das Ende des Paritätsblocks für den nächsten Sector-Cluster 211 enthält. Zusätzlich ist nun angenommen, dass, wenn im letzten Sonderbereich des Sektor-Clusters 211 das dort abgespeicherte Ende des Paritätsblocks den Sonderbereich nicht vollständig ausfüllt, die nachfolgenden Speicherplätze des Sonderbereichs bereits dazu verwendet werden, zumindest den Anfang des Paritätsblocks des nächsten Sektor-Clusters 211 aufzunehmen. Zur besseren Veranschaulichung sind in Fig. 5 die Teile der Paritätsblöcke abwechselnd durch senkrechte und links-schräge Schraffur gekennzeichnet. An einer Sektor-Cluster-Grenze können hier also Teile aufeinanderfolgender Paritätsblöcke in einem Sektor gespeichert werden. Hierbei müssen nicht alle an sich verfügbaren freien Speicherplätze der Sonderbereiche genutzt werden. Insbesondere kann es vorteilhaft sein, sicherzustellen, dass jeder einzelne Paritätsblockteil eine bestimmte Mindestgröße aufweist.

Der Paritätsblock wird entsprechend der Größe der Sonderbereiche in den Sektoren, in denen er abgespeichert werden soll, in Paritätsblockteile unterteilt. Jeder der Paritätsblockteile erhält für Zwecke seiner Zuordnung einen Header 214, der z.B. Angaben über die Größe und ggf. den Beginn des Paritätsblocks, über einen Offset des Paritätsblockteils innerhalb des Paritätsblocks, über ein Cyclic Redundancy Check CRC oder eine Prüfsumme des Paritätsblockteils, und/oder ein Magic Word enthält. Als Magic Word lässt sich jedes Bitmuster verwenden, dass im regulären Bitstrom der ersten Datensätze möglichst selten oder nie vorkommt. Einbettung eines Magic Word ermöglicht es, dass die Paritätsdaten im Gesamtdatenstrom verlässlich und/oder schnell identifiziert werden.

Alternativ hat nur ein erster Paritätsblockteil jedes Paritätsblocks einen solchen oder ähnlichen Header, oder weitere Paritätsblockteile des Paritätsblocks weisen weniger Angaben auf.

Unabhängig davon, ob als Bereiche, über die die Paritätsblöcke jeweils gebildet werden, Sektor-Cluster oder VOBUs verwendet werden, können wie beschrieben mehrere Paritätsblöcke anstatt einem gebildet werden. Auf diese Weise können auch mehrere benachbarte defekte Sektoren repariert werden.

Es ist auch vorteilhaft, mehrere Schutzdatensätze vorzusehen und gemeinsam in die ersten Datensätze einzubetten, wenn diese Schutzdatensätze aus unterschiedlich umfangreichen Teilmengen der ersten Datensätze gebildet werden. Hierzu muss man berücksichtigen, dass die erfindungsgemäßen Verfahren bei Verwendung von Paritätsdaten genau dann ihre Fehlerschutzwirkung aufweisen, wenn genau einer der jeweils zu einem Schutzdatensatz gehörenden ersten Datensätze fehlerhaft ist. Bei mehr als einem fehlerhaften ersten Datensatz ist eine Korrektur mithilfe von Paritätsdaten nicht mehr möglich. Betrachten wir nun ein durch zunehmende mechanische Abnutzung langsam immer schlechter werdendes, d.h. ein eine langsam anwachsende Fehlerwahrscheinlichkeit aufweisendes Speichermedium. Bei zunächst sehr geringer Abnutzung wird ein gemäß der vorgegebenen Konvention angenommener Grund-Fehlerschutz alle Datenfehler korrigieren können, sodass die Verfahren gemäß der Erfindung nicht aktiviert werden. Bei etwas größerer Fehlerwahrscheinlichkeit wird der schützbare Fall tendenziell zuerst für diejenigen Schutzdatensätze auftreten, die aus der größten Anzahl von ersten Datensätzen hergeleitet worden sind. Bei weiter anwachsender Fehlerwahrscheinlichkeit werden für diese Art von Schutzdatensätzen zunehmend mehr Doppel- oder sogar Dreifachfehler innerhalb der zugeordneten ersten Datensätze auftreten. Die zur Anwendung der erfindungsgemäßen Verfahren erforderlichen Einfachfehler werden dann in immer stärkerem Anteil bei denjenigen anderen Arten von Schutzdatensätzen auftreten, die auf kleineren Anzahlen von ersten Datensätzen beruhen.

Das in diesem Fall zweckmäßige Decodierverfahren besteht also darin, die zu den Schutzdatensätzen jedes Bereichs gehörenden Mengen von ersten Datensätzen in Reihenfolge abnehmender Mächtigkeit daraufhin zu untersuchen, ob in der jeweiligen aktuellen Menge genau ein erster Datensatz fehlerhaft ist. Sobald dieser Fall festgestellt wird, kann der eine fehlerhafte erste Datensatz mithilfe des Schutzdatensatzes korrigiert werden, und für die Wiedergabe des Bereichs muss dasjenige Wiedergabeverfahren ausgewählt werden, das bei Vorliegen einer fehlerfreien aktuellen Menge von ersten Datensätzen angemessen ist. Wenn beispielsweise ein Speichermedium erste Schutzdatensätze enthält, die aus allen Videodatensätzen gebildet sind, zweite Schutzdatensätze, die nur aus den I- und P-Picture Daten gebildet sind, und dritte Schutzdatensätze, die nur aus den I-Picture Daten gebildet sind; und wenn dann der schützbare Fall für die zweiten Schutzdatensätze eines Bereichs eintritt, so kann für diesen Bereich ein Wiedergabeverfahren gewählt werden, das nur I-und P-Picture Daten benötigt. Ein solches Wiedergabeverfahren würde z.B. darin bestehen, dass anstelle einer Decodierung und Wiedergabe von B-Pictures die jeweils zuvor decodierten I- oder P-Pictures angemessen oft wiederholt wiedergegeben werden.

**Figur 6** zeigt ein Blockschaltbild eines Abspielgeräts mit Mitteln zum Korrigieren von Fehlern beim Lesen von auf einem Speichermedium gespeicherten Daten. Das Abspielgerät umfasst Mittel zum Erkennen von Fehlern 5, Mittel zum Auswerten der Schutzdatensätze mit einem Filter 4, einem ersten Pufferspeicher 2, einem zweiten Pufferspeicher 3 sowie Mittel zum Ersetzen 6 der fehlerhaften ersten Datensätze durch korrigierte erste Datensätze. Das Abspielgerät ist vorzugsweise mit der Vorrichtung zum Speichern in einem Gerät zusammengefasst, z.B. in einem Videorecorder. Beim Abspielen des Speichermediums liest ein Laser 1 die Daten von dem Speichermedium und speichert sie in den Pufferspeichern 2, 3 zwischen, wobei das Filter 4 die ersten Datensätze in den ersten Pufferspeicher 2 und die Schutzdatensätze in den zweiten Pufferspeicher 3 leitet. Im normalen, fehlerfreien Betrieb werden die ersten Datensätze entsprechend der gestrichelten Linie über einen Demultiplexer 7, drei Decoder 8 und einen Mischer 9 zu einer Ausgabe 10 gegeben.

Sobald die Mittel zum Erkennen von Fehlern 5 einen Fehler in einem der ersten Datensätze entdecken, wird der fehlerhafte Datensatz zusammen mit dem zugehörigen Schutzdatensatz in die Mittel zum Korrigieren 6 geleitet und von diesen mit Hilfe des Schutzdatensatzes korrigiert, d.h. wiederhergestellt. Der korrigierte erste Datensatz wird dann im richtigen Zeitpunkt an den Demultiplexer 7 geleitet und so an der richtigen Stelle in den Datenstrom eingereiht und weiter verarbeitet. Bei Audio- Daten wird der Mischer 9 umgangen.

Bei einer besonderen Ausführungsart weist das Abspielgerät zusätzlich einen internen nichtflüchtigen Datenspeicher und Mittel zum Speichern der korrigierten ersten Datensätze auf dem internen Datenspeicher auf. Wenn hier beim Abspielen eines nicht beschreibbaren optischen Speichermediums ein Fehler entdeckt wird, wird zusätzlich zu dem oben beschriebenen Vorgehen der korrigierte erste Datensatz auf dem internen Datenspeicher zusammen mit einer Bereichskennung und einer Kennung des optischen Speichermediums gespeichert. Gleichzeitig können dem fehlerhaften Bereich benachbarte Bereiche auf dem internen Datenspeicher ebenfalls mit Bereichskennung gespeichert werden, weil die Wahrscheinlichkeit hoch ist, dass diese benachbarten Bereiche ebenfalls unlesbar werden. Wenn ein optisches Speichermedium einen vorbestimmten Grenzwert von Fehlern überschritten hat, wird an den Benutzer des Abspielgeräts ein Signal ausgegeben, das ihm das Kopieren des optischen Speichermediums empfiehlt. Bei diesem Kopieren werden dann fehlerhafte Bereiche durch die korrigierten Bereiche ersetzt.

Mit anderen Worten: Vorgefertigte Speichermedien werden beim Speichern audiovisueller Inhalte oft nicht vollständig beschrieben, es verbleibt ein Sonderbereich. Bekannte Aufzeichnungsformate sehen aus unterschiedlichen Gründen oft Bereiche vor, die frei von für eine Wiedergabe relevanter Information sind und daher einen weiteren Sonderbereich darstellen. Die Erfindung schlägt vor, aus den Daten des bekannten Aufzeichnungsformats Schutzinformationen zu bilden, die Schutzinformationen in den Sonderbereichen einzubetten und mit abzuspeichern, und im Fall von auftretenden Fehlern die Schutzinformationen zu einer Rekonstruktion der gelesenen Daten zu verwenden. Bevorzugt werden die Schutzinformationen eines bestimmten Bereichs in Sonderbereichen eines vorhergehenden Bereichs gespeichert, was eine Echtzeit-Korrektur ermöglicht.

## Patentansprüche

1. Verfahren zum Speichern von Daten auf einem Speichermedium, umfassend die Schritte
- Abspeichern erster Datensätze, die insgesamt zum Lesen der Daten nach einer vorgegebenen Konvention erforderlich sind und Sonderbereiche an unregelmäßigen, aber gemäß der vorgegebenen Konvention ermittelbaren Positionen enthalten, die beim Lesen gemäß der vorgegebenen Konvention nicht verwendet werden; und
- Bilden von Schutzdatensätzen, die Schutzinformationen über die ersten Datensätze enthalten, das Verfahren **gekennzeichnet durch** den Schritt
- Abspeichern der Schutzdatensätze auf dem Speichermedium eingebettet in die Sonderbereiche.

2. Verfahren nach Anspruch 1, angewendet auf Daten, die in eine Folge von nacheinander wiederzugebenden Bereichen unterteilt sind, wobei beim Abspeichern der Schutzdatensätze die zu den ersten Datensätzen eines Bereichs gebildeten Schutzdatensätze eingebettet in die ersten Datensätze mindestens eines der vorherigen Bereiche abgespeichert werden.

3. Verfahren nach Anspruch 1 oder 2, wobei die Schutzinformationen aus den ersten Datensätzen gebildete Paritätsdaten umfassen.

4. Verfahren nach einem der Ansprüche 1 bis 3, umfassend den Schritt Auswahl, aus den ersten Datensätzen, von wesentlichen Daten, wobei das Bilden von Schutzdatensätzen ausschließlich aus den wesentlichen Daten erfolgt.

5. Verfahren nach einem der Ansprüche 1 bis 4, wobei die ersten Datensätze mindestens zwei Datenarten aus einer Menge von Datenarten umfassen, wobei reduzierte erste Datensätze durch Ausblenden der ersten Datensätze mindestens einer der mindestens zwei Datenarten erzeugt werden, und wobei das Bilden der Schutzinformationen ausschließlich aus den reduzierten ersten Datensätzen erfolgt.

6. Verfahren nach Anspruch 5, wobei die Menge von Datenarten die Datenarten I-Picture Daten, P-Picture Daten, B-Picture Daten und Nicht-Video Daten umfasst.

7. Vorrichtung zum Speichern von Daten auf einem Speichermedium nach dem Verfahren der Ansprüche 1 bis 6, mit mindestens einem internen beschreibbaren Datenspeicher,
**dadurch gekennzeichnet, dass** Mittel zum Bilden von Schutzdatensätzen aus ersten Datensätzen, Mittel zum Zwischenspeichern der Schutzdatensätze auf dem internen Datenspeicher und Mittel zum Speichern der ersten Datensätze und der Schutzdatensätze auf dem Speichermedium angeordnet sind.

8. Verfahren zum Korrigieren von Fehlern beim Lesen von auf einem Speichermedium gespeicherten Daten in einem Abspielgerät, wobei das Speichermedium umfasst:
- erste Datensätze, die zum Lesen der Daten gemäß der vorgegebenen Konvention erforderlich sind,
- beim Lesen gemäß der vorgegebenen Konvention nicht verwendete Sonderbereiche an unregelmäßigen, aber gemäß der vorgegebenen Konvention ermittelbaren Positionen, und
- eingebettet in die Sonderbereiche Schutzdatensätze, die Schutzinformationen über die ersten Datensätze enthalten; das Verfahren **gekennzeichnet durch** die Schritte
- Lesen der Schutzdatensätze zusammen mit den ersten Datensätzen,
- Zwischenspeichern der Schutzdatensätze,
- Verwenden, in Fällen fehlerhafter erster Datensätze, der Schutzdatensätze zur Korrektur der Fehler.

9. Verfahren nach Anspruch 8, wobei zusätzlich die korrigierten ersten Datensätze auf einem internen Datenspeicher des Abspielgeräts gespeichert werden.

10. Verfahren nach Anspruch 9, wobei zusätzlich zu den korrigierten ersten Datensätzen auch diesen benachbarte erste Datensätze auf dem internen Datenspeicher gespeichert werden.

11. Verfahren nach Anspruch 9 oder 10, wobei an einen Benutzer des Abspielgeräts eine Aufforderung zum Sichern des Speichermediums ausgegeben wird, sobald die Anzahl der fehlerhaften ersten Datensätze einen vorbestimmten Wert überschreitet.

12. Abspielgerät mit Mitteln zum Korrigieren von Fehlern beim Lesen von auf einem Speichermedium gespeicherten Daten, wobei das Speichermedium umfasst:
- erste Datensätze, die zum Lesen der Daten gemäß der vorgegebenen Konvention erforderlich sind,
- beim Lesen gemäß der vorgegebenen Konvention nicht verwendete Sonderbereiche an unregelmäßigen, aber gemäß der vorgegebenen Konvention ermittelbaren Positionen, und
- eingebettet in die Sonderbereiche Schutzdatensätze, die Schutzinformationen über die ersten Datensätze enthalten; das Abspielgerät **dadurch gekennzeichnet, dass** die Mittel zum Korrigieren Mittel zum Erkennen von Fehlern, Mittel zum Auswerten der Schutzdatensätze sowie Mittel zum Ersetzen der fehlerhaften ersten Datensätze durch korrigierte erste Datensätze umfassen.

13. Abspielgerät nach Anspruch 12, bei dem Mittel zum Speichern der korrigierten ersten Datensätze auf einem internen Datenspeicher des Abspielgeräts angeordnet sind.

14. Speichermedium, auf dem Daten nach einer vorgegebenen Konvention gespeichert sind, wobei das Speichermedium umfasst:
- erste Datensätze, die zum Lesen der Daten gemäß der vorgegebenen Konvention erforderlich sind,
- beim Lesen gemäß der vorgegebenen Konvention nicht verwendete Sonderbereiche an unregelmäßigen, aber gemäß der vorgegebenen Konvention ermittelbaren Positionen, **dadurch gekennzeichnet, dass** in den Sonderbereichen Schutzdatensätze gespeichert sind, die Schutzinformationen über die ersten Datensätze enthalten.

15. Speichermedium nach Anspruch 14, bei dem die Daten in eine Folge von Bereichen unterteilt sind und bei dem die zu den ersten Datensätzen eines Bereichs gebildeten Schutzdatensätze eingebettet in die ersten Datensätze mindestens eines der vorherigen Bereiche abgespeichert sind.

16. Speichermedium nach Anspruch 14 oder 15, bei dem die Schutzinformationen aus den ersten Datensätzen gebildete Paritätsdaten umfassen.

17. Speichermedium nach einem der Ansprüche 14 bis 16, bei dem die Schutzinformationen ausschließlich aus für das Lesen wesentlichen Daten gebildet sind.

18. Speichermedium nach einem der Ansprüche 14 bis 17, bei dem die Daten mindestens zwei Datenarten der Datenarten I-Picture Daten, P-Picture Daten, B-Picture Daten und Nicht-Video Daten umfassen, und bei dem die Schutzinformationen aus nicht allen dieser Datenarten gebildet sind.

19. Speichermedium nach einem der Ansprüche 14 bis 18, bei dem die Daten in eine Folge von Bereichen unterteilt sind, und bei dem die zu den ersten Datensätzen eines Bereichs gebildeten Schutzdatensätze zusammen mit den ersten Datensätzen mindestens eines der vorherigen Bereiche abgespeichert sind.
